# Europäisches Patentamt
# European Patent Office
# Office européen des brevets

(11) Veröffentlichungsnummer: **0 222 036**
**B1**

(12) **EUROPÄISCHE PATENTSCHRIFT**

(45) Veröffentlichungstag der Patentschrift:
**01.02.89**

(51) Int. Cl.⁴: **G01R 1/073**

(21) Anmeldenummer: **85114375.0**

(22) Anmeldetag: **12.11.85**

(54) Leiterplattenprüfgerät mit einem Kontaktpunktraster erhöhter Kontaktpunktdichte.

(43) Veröffentlichungstag der Anmeldung:
**20.05.87 Patentblatt 87/21**

(45) Bekanntmachung des Hinweises auf die Patenterteilung:
**01.02.89 Patentblatt 89/5**

(84) Benannte Vertragsstaaten:
**AT BE CH DE FR GB IT LI LU NL SE**

(56) Entgegenhaltungen:
**DE-U- 7 031 415**
**US-A- 4 465 972**

(73) Patentinhaber: **MANIA Elektronik Automatisation Entwicklung und Gerätebau GmbH, Technologiepark, D-6395 Weilrod 8(DE)**

(72) Erfinder: **Mang, Paul, Weilbergstrasse 4, D-6384 Schmitten 3(DE)**
Erfinder: **Driller, Hubert, Altkönigstrasse 11, D-6384 Schmitten 3(DE)**

(74) Vertreter: **Ruschke, Hans Edvard et al, Patentanwälte Dipl.-Ing. Olaf Ruschke Dipl.-Ing. Hans E. Ruschke Dipl.-Ing. Jürgen Rost Dipl.-Chem. Dr. U. Rotter Pienzenauerstrasse 2, D-8000 München 80(DE)**

**Beschreibung**

Die vorliegende Erfindung betrifft ein elektronisches Leiterplattenprüfgerät mit einem Kontaktpunktraster nach dem Oberbegriff des Patentanspruches.

Beim Einsatz von herkömmlichen Leiterplattenprüfgeräten besteht eine Schwierigkeit darin, daß die Kontaktpunktdichte bei modernen Leiterplattenbauteilen immer größer wird. Es liegt auf der Hand, daß das Prüfkontaktraster von elektronischen Leiterplattenprüfmaschinen mit einem Kontaktpunktabstand von 1/10 Zoll bzw. 2,54 mm sehr bald nicht mehr ausreicht. Es bietet sich daher scheinbar an, auf den nächst kleineren üblichen Kontaktpunktabstand bei Leiterplatten überzugehen, nämlich auf ein 1/20 Zoll oder 1,27 mm Kontaktpunktabstand, der beispielsweise aus dem Dokument US-A 4 465 972 bereits bekannt ist. Dies hätte zur Folge, daß bei äußeren Abmessungen des Prüfkontaktfeldes von z.B. 600 mm x 600 mm statt ca. 236 Kontaktpunkte jeweils in der X- und Y-Richtung eines rechtwinkligen Koordinatensystems dann 472 Kontaktpunkte in jeder Richtung gegeben sind, d.h., die Zahl der Kontaktpunkte im gesamten Feld steigt von ca. 55.800 auf ca. 223.200, d.h., die Anzahl der Kontaktpunkte vervierfacht sich.

Da jedem Kontaktpunkt bei derartigen elektronischen Leiterplattenprüfgeräten eine erhebliche Menge an sehr teurer Prüfelektronik zugeordnet ist, ergäbe sich für den Käufer eines solchen Leiterplattenprüfgerätes in etwa eine Vervierfachung des Preises, obwohl er in der Praxis kaum jemals die vierfache Zahl an Prüfpunkten benötigen wird, zumal die stark erhöhte Prüfpunktdichte an zu prüfenden Leiterplatten meist nur lokal begrenzt ist.

Ein weiteres Problem bei der angesprochenen, im Prinzip möglichen Halbierung des Kontaktabstandes und der damit einhergehenden Vervierfachung der Anzahl der Kontaktpunkte ergäbe sich aufgrund der mit in Betracht zu ziehenden Stabilität der Prüfstifte. Deren Stabilität nimmt mit der vierten Potenz des Durchmessers ab, woraus folgt, daß die Kontaktstifte nicht beliebig dünn werden können. In der Praxis müssen die Kontaktstifte angesichts der gegenwärtig zur Verfügung stehenden Werkstoffe bzw. deren Elastizitätsmodule mindestens einen Durchmesser in der Größenordnung von 1 mm haben, um bei der normalerweise geforderten Lebensdauer von mehreren Millionen Druckbelastungen eine ausreichende Stabilität zur Aufnahme des Kontaktdruckes zu haben. Bei dem halbierten Kontaktabstand von 1/20 Zoll = 1,27 mm wäre es klar, daß der Abstand zwischen den einzelnen Kontaktstiften in eine Größenordnung geriete, die sehr leicht zu Kurzschlüssen zwischen einzelnen Kontaktstiften führen würde – insbesondere da diese aufgrund des aufgebrachten Kontaktdruckes seitwärts ausfedern können.

Ein weiterer Aspekt bei der Erörterung eines zu verdichtenden Kontaktpunktrasters ist in der Tatsache zu sehen, daß viele Anwender von solchen elektronischen Leiterplattenprüfgeräten Zusatzeinrichtungen haben, die auf den vielfach üblichen Kontaktpunktabstand von 1/10 Zoll = 2,54 mm eingerichtet sind. Es würde daher zu weiteren Investitionen von Seiten des Anwenders von Leiterplattenprüfgeräten nötigen, wenn ohne zwingenden Grund von dem eingeführten Kontaktpunktabstand 1/10 Zoll abgewichen würde.

Hiernach wird es als die der vorliegenden Erfindung zugrundeliegende Aufgabe angesehen, ein Kontaktpunktraster derart anzugeben, daß es einerseits mit dem üblichen Kontaktpunktraster von 1/10 Zoll kompatibel ist, andererseits aber eine erhebliche Erhöhung der Kontaktpunktdichte über den vom Ausgangsraster möglichen Wert hinaus erlaubt, ohne deshalb auf ein Kontaktpunktraster von 1/20 Zoll überzugehen und somit eine Vervierfachung der Prüfelektronik in Kauf nehmen zu müssen.

Diese Aufgabe wird durch den Patentanspruch gelöst. Hierdurch bleibt einerseits im Kontaktpunktraster das 1/10 Zoll-Raster enthalten, andererseits wird die Kontaktpunktdichte erheblich vergrößert – nämlich auf das Doppelte des Ausgangsrasters – ohne auf ein 1/20 Zoll-Raster überzugehen, welches für den Anwender erhebliche Kostennachteile u.a. in Form von stark vermehrter Prüfelektronik mit sich bringt. Durch die erfindungsgemäße Lösung beträgt der kleinste Abstand der einzelnen Kontaktpunkte etwa 1,8 mm, so daß auch die Schwierigkeiten aufgrund der mit dem Durchmesser der Kontaktstifte sehr stark abnehmenden Stabilität derselben ohne weiteres vermieden werden können.

Die erfindungsgemäße Lösung kann auch dadurch gekennzeichnet werden, daß im Zentrum von jeweils 4 benachbarten Kontaktpunkten der Grundmatrix (Ausgangsraster) ein zusätzlicher Kontaktpunkt vorgesehen wird. Es wird als noch im Rahmen der Erfindung liegend angesehen, wenn wahllos oder nach einem bestimmten System einige dieser "zusätzlichen" Kontaktpunkte entfallen oder nicht genau im Zentrum angeordnet sind.

Mit der erfindungsgemäßen Lösung für ein Kontaktpunktraster läßt sich also eine um den Faktor 2 erhöhte durchschnittliche Kontaktpunktdichte verarbeiten. Noch höhere Kontaktpunktdichten können dann zugelassen werden, wenn sie nur lokal begrenzt sind, so daß im Durchschnitt gesehen sich nicht mehr als die doppelte Kontaktpunktdichte des Rasters ergibt. Diese über den Faktor 2 hinaus vergrößerte Dichte kann damit abgefangen werden, daß die Kontaktstifte des Kundenadapters im Bereich der örtlich erhöhten Dichte auf der von der Grundmatrix abgewandten Seite, d.h. zur zu prüfenden Leiterplatte hin, aufeinander zu konvergieren.

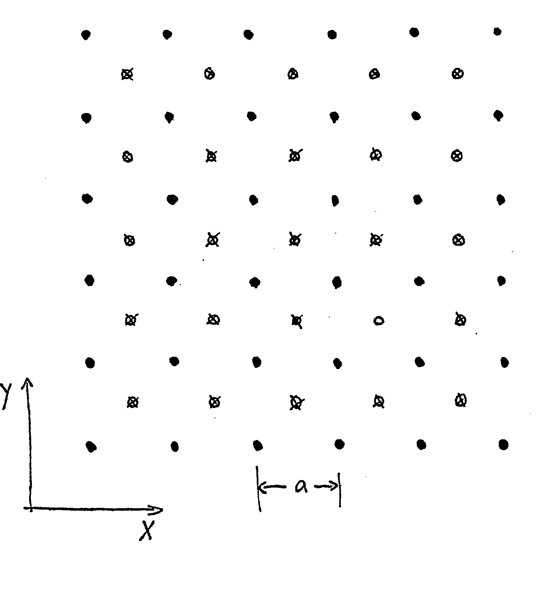

Das neue Kontaktpunktraster wird durch die beigefügte Zeichnung verdeutlicht. Die Kontaktpunkte der Grundmatrix bzw. des Ausgangsrasters sind nach einem rechtwinkligen Koordinatensystem X, Y mit einem Abstand von a = 1/10 Zoll = 2,54 mm in beiden Koordinatenrichtungen angeordnet. Die Kontaktpunkte des Ausgangsrasters sind als schwarze Punkte dargestellt. Jeweils im Zentrum zwischen vier benachbarten derartigen Kontaktpunkten ist ein weiterer Kontaktpunkt vorgesehen, der in der Zeichnung durch einen ein Kreuz enthaltenden Kreis gekennzeichnet ist. Diese weiteren Kontaktpunkte bilden in ihrer Gesamtheit ein mit dem Ausgangsraster identisches weiteres Kontaktpunktraster aus, das gegenüber dem Ausgangsraster in beiden Koordinatenrichtungen um 0,5 a verschoben ist, wobei a der Kontaktpunktabstand des Ausgangsrasters bzw. gleichzeitig des weiteren (überlagerten) Kontaktpunktrasters ist.

## Patentansprüche

Elektronisches Leiterplattenprüfgerät mit einem Kontaktpunktraster (Grundmatrix/Ausgangsmatrix) zur Aufnahme der Prüfstifte eines Adapters (Kundenadapter) zum Anschluß der Prüfpunkte einer zu prüfenden Leiterplatte an die Kontaktpunkte, die nach einem rechtwinkligen Koordinatensystem (X, Y) mit einem Kontaktpunktabstand in beiden Koordinatenrichtungen von a = 1/10 Zoll = 2,54 mm angeordnet sind, dadurch gekennzeichnet, daß diesem Kontaktpunktraster ein identisches weiteres Kontaktpunktraster überlagert ist, das gegenüber dem Ausgangsraster in beiden Koordinatenrichtungen um 0,5 a verschoben ist.

## Claims

Electronic device for testing printed circuit boards with a contact point grid (basic matrix/output matrix) for receiving the test probes of an adapter (custom adapter) to connect the test points of the printed circuit board to be tested to the contact points which are arranged according to a Cartesian coordinate system (X, Y) with a contact point spacing of a = 1/10 inch = 2.54 mm in the direction of both coordinate axes, characterised in that a further identical contact point grid is superimposed on this contact point grid, and is displaced 0.5 a in the direction of both coordinate axes with respect to the output grid.

## Revendications

Appareil électronique de vérification de cartes de circuits imprimés pourvu d'un réseau de points de contact (matrice de base/réseau de départ) destiné à recevoir les broches de contact d'un adaptateur (adaptateur du client) en vue du raccordement des points d'essai du circuit imprimé à vérifier aux points de contact, qui sont disposés selon un système de coordonnées rectangulaires (X, Y) où la distance entre points de contact est de a = 1/10 de pouce = 2,54 mm selon les deux axes, caractérisé en ce qu'à ce réseau de points de contacts est superposé un autre réseau de points de contact identique qui est décalé d'une distance égale à 0,5 a dans les deux axes par rapport au réseau de départ.